# EUROPÄISCHE PATENTANMELDUNG

(11) **EP 2 830 160 A1**
(43) Veröffentlichungstag der Anmeldung: **28.01.2015**
(21) Anmeldenummer: 13306075.6
(22) Anmeldetag: 25.07.2013
(51) Int. Cl.: H01R 4/68, H02G 15/34, H01B 12/16

(54) **Verfahren zum elektrisch leitenden Verbinden von zwei supraleitfähigen Kabeln**

(71) Anmelder: Nexans, 75008 Paris (FR)
(72) Erfinder: Dr. Stemmle, Mark, 30625 Hannover (DE); Schmidt, Frank, 30855 Langenhagen (DE)
(74) Vertreter: Döring, Roger

(57) **Zusammenfassung**

Es wird ein Verfahren zum elektrisch leitenden Verbinden von zwei supraleitfähigen Kabeln (1,2) angegeben, die jeweils mindestens zwei konzentrisch zueinander angeordnete und jeweils von einem Dielektrikum umgebene supraleitfähige Leiter (2,4) sowie einen über dem äußeren Dielektrikum angebrachten, elektrisch wirksamen Schirm (6) aufweisen. Die zu verbindenden Leiter und Schirme werden an den Enden der beiden Kabel (1,2) zunächst von umgebenden Schichten befreit und danach elektrisch leitend miteinander verbunden. Die Enden der beiden Kabel (1,2) werden dazu derart nebeneinander und parallel zueinander angeordnet, daß ihre freien Enden in entgegengesetzte Richtung weisen und ihre Leiter zumindest annähernd auf gleicher Höhe nebeneinander liegen. Die beiden Kabel (1,2) werden relativ zueinander festgelegt. Je zwei Leiter der beiden Kabel werden durch sich quer zu ihrer Achsrichtung erstreckende, elektrische Kontaktelemente (10,11,12) elektrisch leitend miteinander verbunden. Die Schirme (6) der beiden Kabel (1,2) werden mittels separater Kontaktelemente (13,14,15) durchverbunden und die beiden derart behandelten Kabelenden werden beim Aufbau einer Übertragungsstrecke für elektrische Energie gemeinsam in einem Gehäuse (16) eines Kryostats angeordnet, das beim Betrieb der Übertragungsstrecke von einem fließfähigen Kühlmittel mit elektrisch isolierenden Eigenschaften durchströmt wird.

## Beschreibung

Die Erfindung bezieht sich auf ein Verfahren zum elektrisch leitenden Verbinden von zwei supraleitfähigen Kabeln, die jeweils mindestens zwei konzentrisch zueinander angeordnete und jeweils von einem Dielektrikum umgebene supraleitfähige Leiter sowie einen über dem äußeren Dielektrikum angebrachten, elektrisch wirksamen Schirm aufweisen, mit welchem die zu verbindenden Leiter und Schirme an den Enden der beiden Kabel zunächst von umgebenden Schichten befreit und danach elektrisch leitend miteinander verbunden werden (EP 1 552 536 B1).

Supraleitfähige Kabel sind in unterschiedlichsten Ausführungsformen seit langem bekannt. Das gilt grundsätzlich auch für Techniken zum elektrischen Verbinden von zwei supraleitfähigen Kabeln. Ein wesentlicher Unterschied der supraleitfähigen Kabel gegenüber herkömmlichen Kabeln besteht darin, daß dieselben elektrische Leiter aus einem Material haben, das bei ausreichend tiefen Temperaturen in den supraleitfähigen Zustand übergeht, mit einem bei Null liegenden elektrischen Gleichstromwiderstand. Geeignete supraleitfähige Materialien sind beispielsweise oxidische Materialien auf Basis seltener Erden. Ausreichend niedrige Temperaturen, um ein derartiges Material in den supraleitfähigen Zustand zu bringen, liegen beispielsweise zwischen 67 K und 110 K. Geeignete Kühlmittel für all diese Materialien sind beispielsweise Stickstoff, Helium, Neon und Wasserstoff oder Gemische dieser Stoffe. Beim Betrieb einer Übertragungsstrecke für elektrische Energie mit mindestens einem supraleitfähigen Kabel wird dasselbe in bekannter Technik in einem Kryostat angeordnet, der aus mindestens einem thermisch isolierten Rohr besteht, durch welches beim Betrieb der Übertragungsstrecke ein für das eingesetzte supraleitfähige Material geeignetes Kühlmittel geleitet wird, mit Vorteil eines der im Vorangehenden angeführten Kühlmittel.

In Übertragungsstrecken von elektrischer Energie müssen zwei oder mehr Längen eines supraleitfähigen Kabels elektrisch leitend miteinander verbunden werden. Das bedeutet, daß die Leiter und die Schirme der beiden Kabel zunächst von umgebenden Schichten befreit werden müssen. Nach dem elektrisch leitenden Verbinden von je zwei Leitern der beiden Kabel müssen die entfernten Schichten, das sind im wesentlichen die Dielektrika, in bekannter Technik wieder aufgebracht werden. Das geschieht beispielsweise durch das Aufwickeln von Bändern aus Isoliermaterial auf die ganze Verbindungsstelle einschließlich der beiden Leiter. Danach können die darüber liegenden Leiter und die Schirme ebenfalls elektrisch leitend verbunden und in gleicher Weise isoliert werden. Das ist bereits bei Kabeln mit nur einem Leiter und einem Schirm sehr aufwendig und zeitraubend und es erfordert außerdem den Einsatz von Fachpersonal. Bei einem Kabel mit zwei oder drei konzentrisch zueinander angeordneten und gegeneinander isolierten Leitern, wie es beispielsweise aus der eingangs erwähnten EP 1 552 536 B1 hervorgeht, ist der Aufwand extrem hoch, zumal dabei sichergestellt sein muß, daß die Wandstärke der wiederhergestellten Isolierung bzw. Isolierungen zumindest nicht wesentlich größer als die ursprüngliche Wandstärke ist. Nur dann können die Abmessungen eines die Verbindungsstelle umgebenden Kryostats so klein gehalten werden, daß sie den Betrieb der Übertragungsstrecke, insbesondere die Strömung des Kühlmittels durch den Kryostat, nicht behindert.

Der Erfindung liegt die Aufgabe zugrunde, das eingangs geschilderte Verfahren so zu gestalten, daß zwei supraleitfähige Kabel mit mindestens zwei konzentrisch zueinander angeordneten Leitern mit wesentlich vermindertem Aufwand elektrisch leitend verbunden werden können.

Diese Aufgabe wird gemäß der Erfindung dadurch gelöst,
- daß die Enden der beiden Kabel derart nebeneinander und parallel zueinander angeordnet werden, daß ihre freien Enden in entgegengesetzte Richtung weisen und ihre Leiter zumindest annähernd auf gleicher Höhe nebeneinander liegen,
- daß die Enden der beiden Kabel relativ zueinander festgelegt werden,
- daß je zwei Leiter der beiden Kabel durch sich quer zu ihrer Achsrichtung erstreckende, elektrische Kontaktelemente elektrisch leitend miteinander verbunden werden,
- daß die Schirme der beiden Kabel mittels separater Kontaktelemente elektrisch leitend durchverbunden werden und
- daß die beiden derart behandelten Kabelenden beim Aufbau einer Übertragungsstrecke für elektrische Energie gemeinsam in einem Gehäuse eines Kryostats angeordnet werden, das beim Betrieb der Übertragungsstrecke von einem fließfähigen Kühlmittel mit elektrisch isolierenden Eigenschaften durchströmt wird

Im Folgenden wird der Einfachheit halber statt der Worte "Supraleitfähiger Leiter" nur das Wort "Leiter" verwendet.

Der wesentliche Vorteil dieses Verfahrens besteht darin, daß nach dem elektrisch leitenden Verbinden der Leiter - unabhängig von deren Anzahl - und des Schirms keine isolierenden Schichten auf die Verbindungsstellen der jeweiligen Leiter aufgebracht werden müssen. Der Aufwand zum Verbinden der beiden Kabel ist dadurch wesentlich herabgesetzt. Das gilt sowohl für die Einsparung von Isoliermaterial als auch für die zeitraubende Tätigkeit eines Monteurs.

Dieser Vorteil kommt dann verstärkt zum Tragen, wenn die zu verbindenden Kabel drei konzentrisch zueinander angeordnete Leiter haben. In bisheriger Technik muß jeweils nach dem elektrisch leitenden Verbinden von zwei Leitern der beiden Kabel zunächst die Isolierschicht bzw. das Dielektrikum für diese Leiter wieder hergestellt werden, bevor die jeweils darüber liegenden beiden Leiter durchverbunden werden können.

Wichtig für das Verfahren und die entsprechende Anordnung ist auch, daß die Enden der beiden Kabel parallel zueinander verlaufend, relativ zueinander mechanisch festgelegt werden, so daß die sich quer zu ihrer Achsrichtung erstreckenden elektrischen Kontaktelemente auf einfache Art und Weise auf den jeweiligen Leitern montiert und bei einer Bewegung der Kabelenden nicht beschädigt werden können.

Da die beiden supraleitfähigen Kabel mit ihren Enden in entgegengesetzter Richtung weisen, liegt bei einem Kabel mit zwei konzentrisch zueinander angeordneten Leitern, der jeweils innere Leiter des einen Kabels jeweils neben dem äußeren Leiter des anderen Kabels. Es werden daher durch die Kontaktelemente jeweils ein innerer und ein äußerer Leiter elektrisch leitend miteinander verbunden. Dadurch wird die Impedanz der einzelnen Leiter vergleichmäßigt, mit entsprechend verbessertem Übertragungsverhalten der ganzen Kabelstrecke. Das macht sich besonders vorteilhaft bei Übertragungsstrecken mit mehr als zwei entsprechend diesem Verfahren verbundenen Kabelabschnitten bemerkbar. Dieser Vorteil gilt auch für supraleitfähige Kabel mit drei konzentrisch zueinander angeordneten Leitern, weil hier jeweils die inneren Leiter mit den äußeren Leitern des jeweils anderen Kabels elektrisch leitend verbunden werden. Die jeweils mittleren Leiter beider Kabel werden dabei immer miteinander verbunden.

Das Verfahren kann grundsätzlich außerhalb eines Kryostats durchgeführt werden. Es ist jedoch von besonderem Vorteil, wenn die beiden Kabel bereits jeweils in einem sie umgebenden Kryostat angeordnet und nach dem Freilegen der Leiter und der Schirme in ein als Kryostat ausgeführtes Gehäuse eingeführt werden. Dabei können sie in dem Gehäuse zunächst mechanisch festgelegt werden, bevor die Kontaktelemente angebracht werden.

Das Verfahren nach der Erfindung und eine mit demselben hergestellte Anordnung werden als Ausführungsbeispiele anhand der Zeichnungen erläutert.

Es zeigen:
Fig. 1 einen Schnitt durch ein supraleitfähiges Kabel mit zwei konzentrisch zueinander angeordneten Leitern.
Fig. 2 die entgegengesetzt gerichteten Enden von zwei Kabeln nach Fig. 1 mit stufenweise abgesetzten Schichten ihres Aufbaus.
Fig. 3 schematisch eine in einem Kryostat angeordnete Verbindungsstelle von zwei Kabeln mit drei konzentrisch zueinander angeordneten supraleitfähigen Leitern.

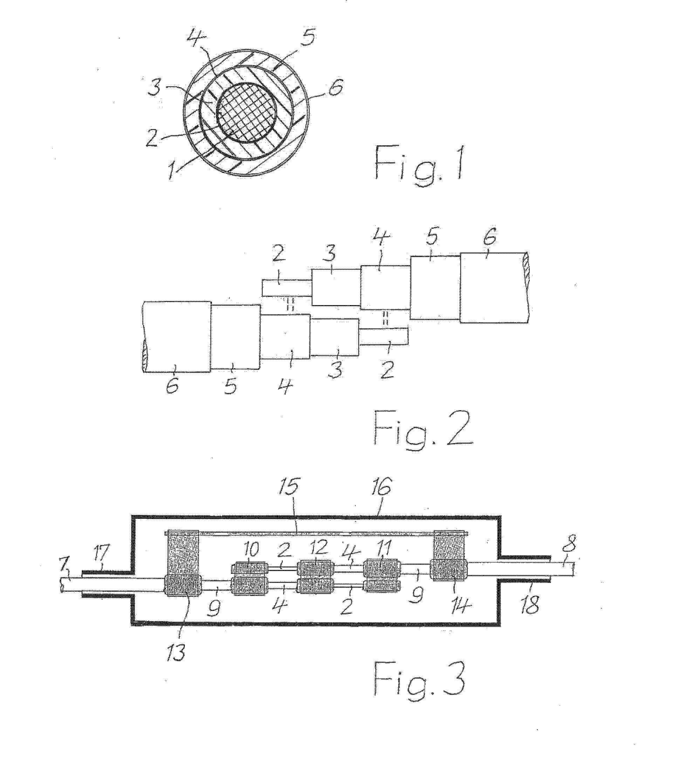

Das Verfahren nach der Erfindung soll zum einfachen elektrisch leitenden Verbinden von zwei supraleitfähigen Kabeln eingesetzt werden, die mindestens zwei konzentrisch zueinander angeordnete Leiter haben. Ein entsprechendes Kabel wird anhand der Fig. 1 und 2 erläutert. Eine Anordnung mit zwei supraleitfähigen Kabeln, welche drei konzentrisch zueinander angeordnete Leiter aufweisen, ist in Fig. 3 schematisch dargestellt. Die beiden Kabel sind mit dem Verfahren nach der Erfindung elektrisch leitend miteinander verbunden.

Das Kabel nach den Fig. 1 und 2 weist einen auch als "Former" bezeichneten Träger 1 auf, um den herum ein Leiter 2 angeordnet ist. Der Leiter 2 ist von einem Dielektrikum 3 umgeben, um welches herum konzentrisch zum Leiter 2 ein Leiter 4 angebracht ist. Der Leiter 4 ist seinerseits von einem Dielektrikum 5 umgeben, auf dem ein elektrisch wirksamer Schirm 6 aufliegt.

Zum elektrisch leitenden Verbinden von zwei supraleitfähigen Kabeln entsprechend den Fig. 1 und 2 werden deren Leiter 2 und 4 sowie gegebenenfalls auch der Schirm 6 von dieselben umgebenden Schichten befreit, so wie es in Fig. 2 schematisch dargestellt ist. Die beiden Kabel werden dann in entgegengesetzter Richtung weisend parallel zueinander so angeordnet, daß ihre Leiter zumindest annähernd auf gleicher Höhe liegen. Beide Kabel werden in dieser Position relativ zueinander festgelegt. Anschließend werden die Leiter 2 der beiden Kabel mit den Leitern 4 des jeweils anderen Kabels durch quer zu ihrer Achsrichtung verlaufende Kontaktelemente elektrisch leitend miteinander verbunden, die in Fig. 2 durch gestrichelte Linien angedeutet sind. Die Schirme 6 der beiden Kabel werden separat mit einem entsprechenden Kontaktelement elektrisch leitend durchverbunden.

Das Verfahren nach der Erfindung wird im Folgenden anhand von Fig. 3 näher erläutert:

In Fig. 3 sind die Enden von zwei supraleitfähigen Kabeln 7 und 8 schematisch dargestellt, welche neben den Leitern 2 und 4 einen dritten Leiter 9 aufweisen, der konzentrisch zu den beiden Leitern 2 und 4 über dem Dielektrikum 5 angeordnet ist und welcher ebenfalls von einem nicht mit dargestellten Dielektrikum umgeben ist, über welchem jeweils der Schirm 6 liegt. Die Enden der beiden Kabel 7 und 8 weisen in entgegengesetzter Richtung. Sie verlaufen parallel zueinander und sind relativ zueinander mechanisch festgelegt. Ihre Leiter 2, 4 und 9 liegen zumindest annähernd auf gleicher Höhe.

In der in Fig. 3 dargestellten Position werden die Leiter 2 der beiden Kabel 7 und 8 mit den Leitern 9 des jeweils anderen Kabels durch Kontaktelemente 10 bzw. 11 elektrisch leitend miteinander verbunden, welche quer zur Achsrichtung der beiden Kabel 7 und 8 verlaufen. Die beiden Leiter 4 der beiden Kabel 7 und 8 werden durch ein Kontaktelement 12 elektrisch leitend miteinander verbunden, das ebenfalls quer zur Achsrichtung der beiden Kabel 7 und 8 verläuft.

Auf den beiden Schirmen 6 der beiden Kabel 7 und 8 werden Kontaktelemente 13 und 14 angebracht, die unabhängig von den Kontaktelementen 10, 11 und 12 und mit Abstand zu denselben durch ein Verbindungselement 15 elektrisch leitend miteinander verbunden werden.

Die so mechanisch festgelegten und elektrisch miteinander verbundenen Kabelenden können zum Aufbau einer Übertragungsstrecke für elektrische Energie in ein in Fig. 3 angedeutetes, als Kryostat ausgeführtes Gehäuse 16 eingebracht werden. Beim Betrieb der Übertragungsstrecke durchströmt das eingesetzte Kühlmittel, beispielsweise flüssiger Stickstoff, auch das Gehäuse 16. Das Kühlmittel ist gleichzeitig isolierendes Medium für die beiden Kabel 7 und 8 bzw. deren Leiter 2, 4 und 9 sowie Schirme 6, so daß - wie bereits erwähnt - auf das Anbringen von Isoliermaterial verzichtet werden kann.

In bevorzugter Ausführungsform werden die Kabel 7 und 8 zunächst jeweils in einem Kryostat angeordnet, aus dem sie jeweils so weit herausragen, daß ihre Leiter und Schirme im geschilderten Sinne freigelegt werden können. Die Enden von entsprechenden Kryostaten 17 und 18 sind in Fig. 3 angedeutet. Sie sind mit dem als Kryostat ausgeführten Gehäuse 16 verbunden. Beim Einführen der Enden der beiden Kabel 7 und 8 in das Gehäuse 16 können sie durch im Gehäuse befindliche Halteelemente mechanisch relativ zueinander festgelegt werden.

Die elektrischen Kontaktelemente 10, 11 und 12 sowie 14 mit Verbindungselement 15 können innerhalb des Gehäuses 16 montiert werden. Das entsprechend gestaltete Gehäuse 16 ist dazu zunächst noch offen. Es wird abschließend verschlossen.

## Patentansprüche

1. Verfahren zum elektrisch leitenden Verbinden von zwei supraleitfähigen Kabeln, die jeweils mindestens zwei konzentrisch zueinander angeordnete und jeweils von einem Dielektrikum umgebene supraleitfähige Leiter sowie einen über dem äußeren Dielektrikum angebrachten, elektrisch wirksamen Schirm aufweisen, mit welchem die zu verbindenden Leiter und Schirme an den Enden der beiden Kabel zunächst von umgebenden Schichten befreit und danach elektrisch leitend miteinander verbunden werden, **dadurch gekennzeichnet,**
- **daß** die Enden der beiden Kabel (7,8) derart nebeneinander und parallel zueinander angeordnet werden, daß ihre freien Enden in entgegengesetzte Richtung weisen und ihre Leiter (2,4,9) zumindest annähernd auf gleicher Höhe nebeneinander liegen,
- **daß** die Enden der beiden Kabel (7,8) relativ zueinander festgelegt werden,
- **daß** je zwei Leiter der beiden Kabel (7,8) durch sich quer zu ihrer Achsrichtung erstreckende, elektrische Kontaktelemente (10,11,12) elektrisch leitend miteinander verbunden werden,
- **daß** die Schirme (6) der beiden Kabel (7,8) mittels separater Kontaktelemente (13,14,15) elektrisch leitend durchverbunden werden und
- **daß** die beiden derart behandelten Kabelenden beim Aufbau einer Übertragungsstrecke für elektrische Energie gemeinsam in einem Gehäuse (16) eines Kryostats angeordnet werden, das beim Betrieb der Übertragungsstrecke von einem fließfähigen Kühlmittel mit elektrisch isolierenden Eigenschaften durchströmt wird.

2. Verfahren nach Anspruch 1, **dadurch gekennzeichnet,**
- **daß** jedes der beiden Kabel (7,8) zunächst so in einem mit dem Gehäuse (16) verbundenen Kryostat (17,18) angebracht wird, daß das jeweilige Kabelende aus dem zugehörigen Kryostat herausragt und in das Gehäuse (16) hineinragt,
- **daß** die beiden Kabelenden in dem noch offenen Gehäuse (16) mechanisch miteinander verbunden werden,
- **daß** die Kontaktelemente (10 bis 14) innerhalb des Gehäuses (16) auf den freigelegten Leitern (2,4,9) und Schirmen (6) der beiden Kabel (7,8) angebracht werden,
- **daß** eine leitende Verbindung zwischen den Schirmen (6) der beiden Kabel (1,2) hergestellt wird und
- **daß** das Gehäuse (16) abschließend verschlossen wird.

3. Mit dem Verfahren nach Anspruch 2 hergestellte Anordnung, **dadurch gekennzeichnet,**
- **daß** in einem als Kryostat ausgeführten Gehäuse (16) die Enden von zwei supraleitfähigen Kabeln (7,8) angeordnet sind, deren Leiter (2,4,9) und Schirme (6) an diesen Enden von umgebenden Schichten befreit sind,
- **daß** die Leiter (2,4,9) der beiden Kabel (7,8) durch sich quer zu ihrer Achsrichtung erstreckende, elektrische Kontaktelemente (10,11,12) elektrisch leitend miteinander verbunden sind und
- **daß** die Schirme (6) der beiden Kabel (7,8) mittels separater Kontaktelemente (13,14,15) elektrisch leitend durchverbunden sind.

## Geänderte Patentansprüche

### Geänderte Patentansprüche gemäss Regel 137(2) EPÜ.

1. Verfahren zum elektrisch leitenden Verbinden von zwei supraleitfähigen Kabeln (7,8), die jeweils mindestens zwei konzentrisch zueinander angeordnete und jeweilsvon einem Dielektrikum umgebene supraleitfähige Leiter (2,4,9) sowie einen überdem äußeren Dielektrikum angebrachten, elektrisch wirksamen Schirm (6) aufweisen, mit welchem die zu verbindenden Leiter (2,4,9) und Schirme (6) an den Enden der beiden Kabel (7,8) zunächst von umgebenden Schichten befreit und danach elektrisch leitend mit einander verbunden werden, **dadurch gekennzeichnet,**
- **daß** die Enden derbeiden Kabel (7,8) derart neben einander und parallel zueinander angeordnet werden, daß ihre freien Enden in entgegengesetzte Richtung weisen und ihre Leiter (2,4,9) zumind e st annähernd auf gleicher Höhe neben einander liegen,
- **daß** die Enden der beiden Kabel (7,8) relativ zueinander festgelegt werden,
- **daß** je zweileiterderbeiden Kabel (7,8) durch sich querzu ihrer Achsrichtung erstreckende, elektrische Kontaktelemente (10,11,12) elektrischleitend miteinander verunden werden,
- **daß** die Schirme (6) derbeiden Kabel (7,8) mittels separater Kontaktelemente (13,14,15) elektrischleitend durch verbunden werden und
- **daß** die beiden derart behandelten Kabelenden beim Aufbau einer Übertragungsstrecke für elektrische Energie gemeinsam in einem Gehäuse (16) eines Kryostats angeordnet werden, das beim Betrieb der Übertragungsstrecke von einem fließfähigen Kühlmittel mit elektrisch isolierenden Eigenschaften durch strömt wird.

2. Verfahren nach Anspruch 1, **dadurch gekennzeichnet,**
- **daß** jedes der beiden Kabel (7,8) zunächst so ineinemmitdemGehäuse (16) verbundenen Kyostat (17,18) angebracht wird, daß das jeweilige Kabelende aus dem zugehörigen Kryostat herausragt und in das Gehäuse (16) hineinragt,
- **daß** die beiden Kabelenden in dem noch offenen Gehäuse (16) mechanisch miteinander verbunden werden,
- **daß** die Kontaktelemente (10 bis 14) innerhalb des Gehäuses (16) auf den freigelegten Leitern (2,4,9) und Schirmen (6) der beiden Kabel (7,8) angebracht werden,
- **daß** eine leitende Verbindung zwischen den Schirmen (6) der beiden Kabel (1,2) hergestellt wird und
- **daß** das Gehäuse (16) abschließend verschlossen wird.

3. Mit d e m Verfahren na c h Anspruch 2 hergestellte Anordnung, **dadurch gekennzeichnet,**
- **daß** in einem als Kryostat ausgeführten Gehäuse (16) die Enden von zwei supraleitfähigen Kabeln (7,8) angeordnet sind, deren Leiter (2,4,9) und Schirme (6) an diesen Enden von umgebenden Schichten befreit sind,
- **daß** die Leiter (2,4,9) derbeiden Kabel (7,8) durch sich quer zu ihrer Achsrichtung erstreckende, elektrische Kontaktelemente (10,11,12) elektrisch le ite nd miteinander verbunden sind und
- **daß** die Schirme (6) der beiden Kabel (7,8) mittels separater Kontaktelemente (13,14,15) elektrisch leitend durch verbunden sind.
